# EUROPÄISCHE PATENTSCHRIFT

(11) **EP 3 582 928 B1**
(45) Veröffentlichungstag und Bekanntmachung des Hinweises auf die Patenterteilung: **11.10.2023**
(21) Anmeldenummer: 18723722.7
(22) Anmeldetag: 23.04.2018
(51) Int. Cl.: B23K 35/26, B23K 35/30, B23K 35/02, H01L 23/00

(54) **LOTFORMTEIL ZUM ERZEUGEN EINER DIFFUSIONSLÖTVERBINDUNG UND VERFAHREN ZUM ERZEUGEN EINES LOTFORMTEILS**
SOLDER PREFORM FOR ESTABLISHING A DIFFUSION SOLDER CONNECTION AND METHOD FOR PRODUCING A SOLDER PREFORM
PRÉFORMÉ DE BRASAGE POUR PRODUIRE UNE JONCTION BRASÉE PAR DIFFUSION ET PROCÉDÉ DESTINÉ À PRODUIRE UN PRÉFORMÉ DE BRASAGE

(30) Priorität: 25.04.2017 DE 102017206932
(43) Veröffentlichungstag der Anmeldung: 25.12.2019
(73) Patentinhaber: Siemens Aktiengesellschaft, 80333 München (DE)
(72) Erfinder: SCHELLENBERG, Christian, 14480 Potsdam (DE); STROGIES, Jörg, 14163 Berlin (DE); WILKE, Klaus, 12527 Berlin (DE)
(74) Vertreter: Siemens Patent Attorneys
(86) Internationale Anmeldenummer: PCT/EP2018/060296
(87) Internationale Veröffentlichungsnummer: WO 2018/197390

(56) Entgegenhaltungen:
- EP-A1- 0 608 905
- JP-A- 2014 180 690
- US-A1- 2009 236 725
- US-A1- 2010 291 399
- US-A1- 2015 155 402
- US-A1- 2016 358 884
- KOTADIA H R ET AL: "Massive spalling of Cu-Zn and Cu-Al intermetallic compounds at the interface between solders and Cu substrate during liquid state reaction", JOURNAL OF APPLIED PHYSICS, AMERICAN INSTITUTE OF PHYSICS, US, vol. 111, no. 7, 1 April 2012 (2012-04-01) , pages 74902-74902, XP012158775, ISSN: 0021-8979, DOI: 10.1063/1.3699359 [retrieved on 2012-04-04]

## Beschreibung

Die Erfindung betrifft ein Lotformteil zum Erzeugen einer Diffusionslötverbindung. Dieses weist eine erste Fügefläche für einen ersten Fügepartner und eine zweite Fügefläche für einen zweiten Fügepartner auf. Das Lotformteil besteht aus einem Gefüge, aufweisend eine erste Phase aus einem Lotwerkstoff und eine zweite Phase aus einem metallischen Werkstoff. Die Verwendung von Diffusionslötverbindungen zum Montieren zweier Fügepartner ist beispielsweise aus der DE 10 2013 219 642 A1 bekannt. Beim Ausbilden von Diffusionslötverbindungen zwischen den Fügepartnern entsteht aufgrund von Diffusionsvorgängen eine Lötverbindung, welche eine intermetallische Phase aufweist, die einen höheren Schmelzpunkt hat als die restliche aus der Lotlegierung bestehenden Lötverbindung. Hierdurch ist es möglich, die Verbindung zwischen den Fügepartnern thermisch und mechanisch zu stabilisieren.

Die Fügepartner können beispielsweise Kontaktmaterialien aus Kupfer zur Verfügung stellen. Das Diffusionslot kann ein Zinn enthaltender Lotwerkstoff sein. Durch die Diffusion von Kupfer in das Lotmaterial während des Ausbildens der Lötverbindung entsteht dann eine Diffusionszone, welche durch eine intermetallische Verbindung zwischen Kupfer und Zinn gebildet wird. Diese weist einen Schmelzpunkt von ungefähr 420°C auf, der damit eindeutig über der Schmelztemperatur des zinnbasierten Lotwerkstoffs liegt. Aufgrund der notwendigen Diffusionsvorgänge kann die Diffusionszone nicht beliebig tief in den Lotwerkstoff hineinreichen. Daher ist die auszubildende Lötverbindung auf eine bestimmte Dicke beschränkt. Gemäß der DE 10 2013 219 642 A1 wird daher vorgeschlagen, zumindest einen der Fügepartner so zu gestalten, dass Hohlräume im Bereich des Fügespalts zwischen den Fügepartnern entstehen. Diese können beispielsweise durch Vorsehen von Vertiefungen in der Montagefläche eines der Fügepartner ausgebildet werden. Sie dienen beim Fügen dann als Pufferräume, in die überschüssiges Lotmaterial entweichen kann, damit auch bei Auftreten von Mengentoleranzen eine Spaltbreite zwischen den Fügepartnern gewährleistet werden kann, die die zuverlässige Ausbildung einer Diffusionszone über die gesamte Breite des Fügespalts sicherstellt.

Gemäß D. Feil: "Fügekonzepte für Leistungsmodule an Kühlkörpern", Elektronische Baugruppen und Leiterplatten, Seiten 60 - 64, Berlin, Offenbach, 2016 ist es außerdem bekannt, dass bei der Ausbildung von Diffusionslötverbindungen auch größere Fügespalte zwischen den Fügepartnern überbrückt werden können, wenn ein flexibles Formteil, wie z. B. ein Kupfernetz, in den Fügespalt eingelegt wird. Auf diesem kann eine Lotfolie platziert werden, wobei das Lotmaterial bei Verflüssigung die Zwischenräume zwischen dem flexiblen Formteil ausfüllt. Das Formteil stellt dabei das Material zur Verfügung, welches in den Lotwerkstoff eindiffundieren kann. Dadurch, dass das diffundierende Material nicht nur durch die Grenzflächen der Fügepartner, sondern auch im Inneren der Lötverbindung zur Verfügung steht, kann sich eine durchgehende Diffusionszone zwischen den Fügepartnern auch bei einem größeren Fügespalt ausbilden.

Feil beschreibt auch eine andere Möglichkeit des Ausbildens von Diffusionslötverbindungen, bei der statt des flexiblen Formteils ein metallisches Pulver verwendet wird, z. B. Kupferpulver. Dieses wird dem Lotmaterial beigemengt und stellt dispers verteilt im Lotwerkstoff das Material zur Verfügung, welches unter Ausbilden der Diffusionszone in die Lötverbindung eindiffundieren kann. Auch hierdurch lässt sich in der Lötverbindung eine Diffusionszone erzeugen, die den Spalt zwischen den beiden Fügepartnern überbrückt.

Gemäß der US 2009/004500 A1 ist es bekannt, dass Diffusionslötverbindungen zwischen zwei Fügepartnern durch Diffusion von Bestandteilen aus einer flüssigen Phase in eine feste Phase während des Lötens erzeugt werden können. Dabei wird ein zwei Komponenten enthaltender Lotwerkstoff zwischen den Fügepartnern verwendet. Um die Lötverbindung herstellen zu können, wird ein Lotformteil zwischen den Fügepartnern platziert, welches aus einem Sandwich von Lagen der ersten Komponente und der zweiten Komponente besteht. Hierdurch ist es möglich, die Diffusionswege für das diffundierende Element möglichst kurz zu halten, so dass sich eine mechanisch stabile Verbindung zwischen den Fügepartnern ergibt.

Die Verwendung von Lotformteilen erfordert eine hohe Präzision bei der Herstellung der Lötverbindungen, da diese zum Ausbilden einer zuverlässigen Kontaktierung beide Fügepartner berühren müssen und die Diffusionswege in der sich ausbildenden Lötverbindung nicht zu groß sein dürfen. Diese Präzision ist mit einem gewissen Fertigungsaufwand und dadurch entstehenden Kosten verbunden. Um die Diffusionswege klein zu halten, können besonders dünne Lotformteile verwendet werden. Diese erfordern jedoch eine sehr ebene und reine Oberfläche der Fügepartner und erhöhte Anforderungen an die Fügegenauigkeit. Auch lassen sich zwecks Verkürzung der Diffusionswege nicht beliebig dünne Formteile herstellen. Auch die Zeit, die für das Phasenwachstum einer intermetallischen Phase benötigt wird, lässt sich nicht beliebig minimieren. Auch muss die thermische Belastung der Fügepartner beachtet werden, die die zulässigen Behandlungszeichen einer Wärmebehandlung begrenzen.

Die US 2015/155402 A1 offenbart ein Lötstellenmaterial, das ein Metallmaterial auf Kupferbasis aufweist, das hauptsächlich Kupfer enthält, eine oberflächenbehandelte Schicht, die auf dem Metallmaterial auf Kupferbasis vorgesehen ist und eine amorphe Schicht enthält, die Sauerstoff und ein Metall mit einer höheren Sauerstoffaffinität als Kupfer enthält, und eine Lötplattierungsschicht auf Sn-Basis, die auf der oberflächenbehandelten Schicht vorgesehen ist.

Die US 2010/291399 A1 offenbart einen Ersatz für ein Hochtemperaturlot mit einer Solidustemperatur von mindestens 250° C zum Verbinden eines Gehäuses und eines Deckels eines Funktionsteils wird eine Lötpaste, die durch Mischen eines Metallpulvers auf Cu-Basis mit einer Solidustemperatur von mindestens 400° C und eines Lötpulvers auf Sn-Basis gebildet wird, auf einen Deckel eines schwer lötbaren Materials aufgebracht, das zuvor einer Beschichtung mit guter Lötbarkeit unterzogen und erhitzt wurde. So wird eine Lötschicht erhalten, die das Metallpulver auf Cu-Basis, intermetallische Cu6Sn5-Verbindungen und bleifreies Lot auf der beschichteten Oberfläche umfasst. Die intermetallischen Verbindungen sind mit dem schwer lötbaren Material verbunden und die intermetallischen Verbindungen sind miteinander verbunden, so dass die Lötschicht als Hochtemperaturlot funktioniert.

Die JP 2014 180690 A offenbart ein plattenförmiges Hochtemperaturlot, umfassend eine Metallfolie, die ein Metall enthält, das mit Sn eine intermetallische Verbindung bildet, und Bedecken der Vorder- und Rückseiten der Metallfolie mit einem Lot auf Sn-Basis, das entweder aus Sn oder einer Lotlegierung auf Sn-Basis hergestellt ist.

Die Aufgabe der Erfindung besteht darin, ein Lotformteil für das Diffusionslöten anzugeben, wobei das Lotformteil einfach bei der Handhabung und Montage der Diffusionslötverbindung sein soll und die thermische Belastung beim Fügen der Diffusionslötverbindung vergleichsweise gering sein soll.

Diese Aufgabe wird mit dem eingangs angegebenen Lotformteil erfindungsgemäß dadurch gelöst, dass in dem Lotformteil eine aus dem Material der ersten Phase und dem Material der zweiten Phase bestehende Diffusionszone ausgebildet ist, wobei die erste Fügefläche und die zweite Fügefläche ganz oder teilweise durch die erste Phase ausgebildet sind. Dabei sind die erste Phase und die zweite Phase ineinander lösbar, d. h., dass der metallische Werkstoff der zweiten Phase in die erste Phase eindiffundiert, wenn die thermische Energie hierfür ausreicht. Dies ist insbesondere dann der Fall, wenn die erste Phase aus dem Lotwerkstoff zwecks Ausbilden der Diffusionslötverbindung aufgeschmolzen wird. Die zweite Phase hat dabei einen höheren Schmelzpunkt und wird daher beim Ausbilden der Diffusionslötverbindung nicht aufgeschmolzen. Die Diffusionsvorgänge führen am Ende zu der Ausbildung einer intermetallischen Phase, die aus Bestandteilen der ersten Phase und der zweiten Phase ausgebildet wird und einen höheren Schmelzpunkt aufweist als der Lotwerkstoff. Die erste Phase ist ein zinnbasierter Lotwerkstoff (insbesondere ein Zinn-Silber-Kuper-Lot wie zum Beispiel SAC305 mit der Legierungszusammensetzung SN96,5Ag3Cu0,5 oder ein Zinn-Kupfer-Lot, zum Beispiel mit der Legierungszusammensetzung Sn99,3Cu0,7), während die zweite Phase aus einem Metall (d.h. Kupfer) besteht, welches sich in der ersten Phase löst und in diese eindiffundiert. Die Erfindung ist in den beigefügten Ansprüchen definiert.

Die erfindungsgemäße Idee liegt darin, dass die Diffusionszone, die in dem Lotformteil ausgebildet ist, das abschließende Stadium des Diffusionsvorgangs noch nicht erreicht hat. Damit lässt sich das Lotformteil im Rahmen eines Diffusionslötvorgangs noch verwenden, um zwei Fügepartner mit einer Diffusionslötverbindung zu verbinden. Hierfür stehen die erste Fügefläche und die zweite Fügefläche zur Verfügung, wobei an diesen beiden Fügeflächen noch die erste Phase ausgebildet ist. Somit steht also das Lotmaterial noch zur Ausbildung einer Diffusionszone zur Verfügung, die dadurch gebildet werden kann, dass die Fügepartner den metallischen Werkstoff, der auch in der zweiten Phase vorliegt, zur Ausbildung der Diffusionszone beitragen.

Beim Ausbilden der Diffusionslötverbindung wird das Lotformteil auf eine Temperatur erwärmt, dass es zu weiteren Diffusionsvorgängen kommt, die die Ausbildung der Diffusionslötverbindung abschließen. Insbesondere können sich intermetallische Phasen ausbilden, die auch bis zu den Fügeflächen reichen und so zu einer zuverlässigen Diffusionslötverbindung zwischen den Fügepartnern führen. Vor dem Verlöten des Lotformteils kann die im Inneren vorliegende Diffusionszone auch schon zumindest teilweise eine intermetallische Phase aufweisen. Dies hängt davon ab, wie lange das Lotformteil einer die Diffusion auslösenden Wärmebehandlung unterworfen wurde. Wichtig ist lediglich, dass zum Ausbilden der Diffusionslötverbindung noch genügend Lotwerkstoff der ersten Phase an den Fügeflächen zur Verfügung steht.

Gemäß der Erfindung ist vorgesehen, dass zwischen der Diffusionszone und der ersten Fügefläche sowie zwischen der Diffusionszone und der zweiten Fügefläche ein Mindestabstand besteht, der im Bereich von mindestens 1 µm und höchstens 30 µm, bevorzugt mindestens 5 µm und höchstens 10 um liegt. Durch den erfindungsgemäß vorgesehenen Abstand wird sichergestellt, dass die Diffusionslötverbindungen zwischen den Fügepartnern und dem Lotformteil mit einem vergleichsweise geringen Wärmeeintrag fertiggestellt werden können. Deswegen ist es vorteilhaft möglich, dass die Diffusionslötverbindungen gemeinsam mit weiteren Lötverbindungen einer elektronischen Baugruppe gefertigt werden. Normalerweise ist für die Herstellung von Diffusionslötverbindungen zwar eine wesentlich höhere Temperatur als für gewöhnliche Lötverbindungen erforderlich. Durch die Diffusionsvorgänge, die in dem Lotformteil beispielsweise durch eine Wärmebehandlung bereits angestoßen wurden, muss die Ausbildung der Diffusionszone mit der intermetallischen Verbindung allerdings nicht vollständig durch den Lötvorgang erzeugt werden. Daher erreichen vorteilhaft die Bearbeitungszeiten und -temperaturen des gewöhnlichen Lötens aus, weswegen die Baugruppe in einem einzigen Lötvorgang gefertigt werden kann, auch wenn neben den Diffusionslötverbindungen auch gewöhnliche Lötverbindungen gefertigt werden sollen. Beispielsweise kann eine solche elektronische Baugruppe in einem Reflow-Lötofen gelötet werden.

Um eine Diffusionszone in der Diffusionslötverbindung zu erzeugen, welche von der einen Fügefläche bis zur anderen Fügefläche reicht, muss der Mindestabstand nicht über die gesamte Fläche der Fügefläche verteilt sein. Der Mindestabstand liegt gemäß der Erfindung in einem Bereich unterhalb der Fügefläche von mindestens 70% vor.

Weiterhin ist erfindungsgemäß vorgesehen, dass zwischen der Diffusionszone und der ersten Fügefläche sowie zwischen der Diffusionszone und der zweiten Fügefläche ein Abstand besteht, der im Bereich von mindestens 1 µm und höchstens 30 µm, bevorzugt mindestens 5 um und höchstens 10 µm liegt, wobei der besagte Abstand zwischen der Diffusionszone und der ersten Fügefläche sowie zwischen der Diffusionszone und der zweiten Fügefläche in einem Bereich unterhalb der Fügefläche von mindestens 70 %, bevorzugt von mindestens 90 % vorliegt. Hierdurch kann vorteilhaft sichergestellt werden, dass sich zumindest im Hauptteil der Fügefläche eine Diffusionsverbindung ausbildet. Diese stabilisiert die Lötverbindung wirksam, auch wenn Reste des Lotwerkstoffes in der Lötverbindung noch vorhanden sind.

Es ist möglich, dass die intermetallische Verbindung so weit ausgebildet ist, dass eine vollständige Durchdringung des Lotformteils durch die Diffusionszone von der ersten Fügefläche zur zweiten Fügefläche in einer Lötzeit von weniger als 300 Sekunden, insbesondere in einer Lötzeit von 60 - 150 Sekunden ausbildbar ist. Es hat sich nämlich gezeigt, dass durch Dimensionierung der Abstände zwischen der Diffusionszone und den Fügeflächen die Lötzeit direkt beeinflusst werden kann. Auf diese Weise gelingt es, dass Lotformteil so auszulegen, dass dieses insbesondere mit gewöhnlichen Lötverbindungen gemeinsam gelötet werden kann.

Es ist möglich, dass die intermetallische Verbindung so weit ausgebildet ist, dass eine vollständige Durchdringung des Lotformteils durch die Diffusionszone von der ersten Fügefläche zur zweiten Fügefläche in einem Temperaturbereich von kleiner 270 °C, insbesondere in einem Temperaturbereich von 220 °C bis 260 °C durchführbar ist. Es hat sich nämlich gezeigt, dass durch geeignete Dimensionierung der Abstände zwischen der Diffusionszone und den Fügeflächen eine Verringerung der Löttemperatur möglich ist, wobei diese so eingestellt werden kann, dass die Diffusionsverbindung gemeinsam mit gewöhnlichen Lötverbindungen gelötet werden kann.

Bei einem Verfahren zum Erzeugen eines Lotformteils, bei dem eine erste Phase aus einem Lotwerkstoff und eine zweite Phase aus einem metallischen Werkstoff zu dem Lotformteil zusammengefügt werden, kann zur Ausbildung der Diffusionszone mit einer intermetallischen Verbindung vorgesehen werden, dass eine Wärmebehandlung durchgeführt wird (hierzu im Folgenden noch mehr). Bei der Anwendung dieses Verfahrens kann die Wärmebehandlung hinsichtlich ihrer Parameter (Temperatur, Wärmebehandlungsdauer) so eingestellt werden, dass die sich obenstehend aufgeführten Verhältnisse für den Abstand zwischen den Fügeflächen und der Diffusionszone einstellen.

Gemäß der Erfindung ist vorgesehen, dass die erste Phase und die zweite Phase als Lagen in dem Lotformteil ausgebildet sind, wobei jeweils zwischen diesen Lagen die Diffusionszonen als Zwischenlagen ausgebildet sind. Mit anderen Worten wechseln sich die Lagen der ersten Phase und der zweiten Phase ab. Durch eine Wärmebehandlung entstehen Zwischenlagen. Diese werden durch Diffusionszonen gebildet, die von der Grenzfläche zwischen der ersten Phase und der zweiten Phase ausgehend wachsen und auch zusammenwachsen können. Die Diffusionszonen können zumindest teilweise in intermetallische Verbindungen umgewandelt werden, wenn die Diffusion weit genug fortgeschritten ist. Vorteilhaft ergibt sich auf diese Weise ein einfacher Aufbau des Lotformteils, welches durch Schichten von Folien aus der ersten Phase und der zweiten Phase hergestellt werden kann.

Möglich, aber nicht Teil der Erfindung, ist, dass die zweite Phase in Form von Partikeln ausgebildet ist, die in einer Matrix aus der ersten Phase verteilt sind. Dies lässt sich beispielsweise dadurch erreichen, dass die Partikel der zweiten Phase zwischen Folien aus der ersten Phase verteilt werden und hieraus ein das Lotformteil bildender Verband erzeugt wird. Besonders vorteilhaft ist es, wenn die anschließend erzeugte Diffusionszone ein die Partikel verbindendes Gerüst einer intermetallischen Verbindung aufweist. Dieses Gerüst erstreckt sich über die Dicke des Lotformteils, wodurch die durch das Lotformteil ausgebildete Diffusionslötverbindung mechanisch und thermisch stabilisiert wird. Nach Montage des Lotformteils und Diffusionslöten desselben wird das Gerüst der intermetallischen Verbindung zu den Fügepartnern hin ergänzt, so dass dieses bis zu den Fügeflächen reicht. Damit wird die gesamte Diffusionslötverbindung stabilisiert.

Eine andere Möglichkeit nicht Teil der Erfindung besteht darin, dass die zweite Phase eine einteilige Raumstruktur ausbildet, die von einer Matrix aus der ersten Phase umgeben ist. Eine solche einteilige Raumstruktur gibt die Geometrie eines in der ersten Phase sich ausbildenden Gerüsts der intermetallischen Verbindung vor, so dass dieses sich vorteilhaft mit definierter Geometrie und daher gut vorhersagbaren mechanischen Eigenschaften ausbilden lässt. So entsteht ein die Raumstruktur umgebendes Gerüst der intermetallischen Phase, dessen Geometrie sich an der Raumstruktur der zweiten Phase orientiert.

Das Lotformteil kann einer Wärmebehandlung unterworfen werden, wobei sich während der Wärmebehandlung eine Diffusionszone zwischen der ersten Phase und der zweiten Phase ausbildet. In dieser Diffusionszone wird es auch zu einer Ausbildung von intermetallischen Verbindungen kommen. Außerdem wird die Wärmebehandlung rechtzeitig abgebrochen, damit an einer ersten Fügefläche für den ersten Fügepartner und an einer zweiten Fügefläche für den zweiten Fügepartner ganz oder teilweise die erste Phase ausgebildet bleibt. Hierdurch wird der Lotwerkstoff an den Fügeflächen zur Herstellung einer Lötverbindung zu den benachbarten Fügepartnern sichergestellt. Dass die erste Phase an den Fügepartnern erhalten bleibt, kann dadurch sichergestellt werden, dass die zweite Phase, aus der Material zur Bildung der Diffusionszone in die erste Phase eindiffundiert, in den Bereichen nahe der Fügeflächen gar nicht oder nur im geringen Umfang vorhanden ist.

Außerdem lässt sich die Ausbildung einer Diffusionszone, die bis an die Fügeflächen heranreicht, durch Begrenzen der Zeit für die Wärmebehandlung beeinflussen.

Mit einem solchen Verfahren lässt sich ein Lotformteil erzeugen, dessen Vorteile vorstehend bereits erläutert wurden. Insbesondere lässt sich ein Lotformteil erzeugen, bei dem der Abschluss der Diffusionsvorgänge, die bei der Montage zur Ausprägung einer Diffusionslötverbindung zwischen zwei Fügepartner führen sollen, schneller erreicht ist. Hierbei lassen sich vorteilhafterweise die thermischen Belastungen, die mit dem Ausbilden der Lötverbindung verbunden sind, verringern.

Das Lotformteil kann während der Wärmebehandlung zwischen zwei Haltevorrichtungen eingesetzt werden, welche an der ersten Fügefläche und an der zweiten Fügefläche angreifen. Diese Haltevorrichtungen dürfen kein Material enthalten, welches in das Lotformteil eindiffundiert, damit diese nach der Wärmebehandlung von dem Lotformteil wieder abgelöst werden können. Beispielsweise können die Haltevorrichtungen aus Keramik bestehen und durch zwei ebene Platten realisiert werden. Vorteilhaft ist es auch, wenn die Haltevorrichtungen durch den Lotwerkstoff schwer benetzbar sind, so dass dieser mit den Grenzflächen der Haltevorrichtungen keine Verbindung eingehen kann. Mit den Haltevorrichtungen kann während der Wärmebehandlung ein Druck auf das Lotformteil ausgeübt werden, um einzelne Lagen miteinander zu verbinden und die Fügeflächen zu konditionieren.

Weiterhin ist es vorteilhaft, wenn als Zwischenprodukt eine Platte erzeugt wird, die die Höhe der herzustellenden Lotformteile aufweist. Aus dieser kann nach Abschluss der Wärmebehandlung eine Vielzahl von Lotformteilen hergestellt werden, indem die Platte zerteilt wird. Dies kann beispielsweise durch Stanzen, Schneiden, Sägen, Trennschleifen oder Laserschneiden erfolgen. Durch Herstellen einer großen Platte lässt sich einerseits die Prozesssicherheit beim Schichten der einzelnen Lagen verbessern. Außerdem verringert sich der Aufwand beim Schichten der Lagen, da für eine Vielzahl von Lotformteilen eine vergleichsweise geringe Anzahl von Bauteilen mit vergleichsweise großen Abmessungen gehandhabt werden muss. Horizontale Lageabweichungen fallen dann beispielsweise jeweils nur am Rand der Platte an und können beim Vereinzeln der Lotformteile einfach abgeschnitten werden.

Gemäß einem Verfahren nicht Teil der Erfindung kann vorgesehen sein, dass die erste Phase in Form von Lagen verwendet wird und die zweite Phase in Form von Partikeln verwendet wird. Die Lagen und die Partikel werden dann abwechselnd geschichtet und die Partikel anschließend in die Lagen eingebettet. Dieser Einbettungsprozess kann beispielsweise mechanisch durch Rollen oder Pressen erfolgen. Unterstützt wird die Ausbildung des Verbunds zwischen den einzelnen Lagen überdies durch die Wärmebehandlung, da die Ausbildung der Diffusionszone zu einer festen Verbindung zwischen den Partikeln und den Lagen führt.

Es können nicht erfindungsgemäß Kupferpartikel in Form von Kugeln auf dünne Lotfolien, insbesondere einer zinnhaltigen Lotlegierung, appliziert werden. Hierbei kann ein Binder zum Einsatz kommen, mit dem die Partikel auf der Lotfolie fixiert werden. Wenn mehrere dieser Folien übereinandergestapelt werden, so lässt sich die gesamte Höhe des so erzeugten Lotformteils ein ausreichender Füllgrad mit Kupferpartikeln erreichen.

Es kann nicht erfindungsgemäß vorgesehen werden, dass die erste Phase in Form von Partikeln oder in Form einer einteiligen Raumstruktur zwischen den Haltevorrichtungen platziert wird und anschließend diese erste Phase von der vorher aufgeschmolzenen zweiten Phase infiltriert wird. Hierbei macht man es sich zunutze, dass die zweite Phase eine niedrigere Schmelztemperatur als die erste Phase aufweist und aufgrund von Kapillarkräften in die Zwischenräume der ersten Phase hineingesogen wird. Hierdurch ergibt sich vorteilhaft ein Verbund aus der ersten Phase und der zweiten Phase, wobei der Füllgrad und die Geometrie der ersten Phase genau vorbestimmt werden, kann. Dadurch, dass das Lotmaterial im flüssigen Zustand in das Lotformteil eingebracht wird, steht außerdem genügend Wärme zur Verfügung, damit sich sofort eine Diffusionszone ausbildet. Der Wärmebehandlungsschritt ist damit zumindest teilweise in den Herstellungsschritt des Lotformteils integriert, wodurch vorteilhaft die Herstellungszeit für das Formteil verringert werden kann.

Werden nicht erfindungsgemäß Kupferpartikel verwendet, so können diese beispielsweise in Form einer Kupferpaste verarbeitet werden, indem diese auf eine nicht benetzbare Fläche, beispielsweise aus einer Keramik, gedruckt werden. Nach Trocknung dieses Partikelverbands kann ein Lotdepot beispielsweise in Form eines Formteils oder eines Lotpastendepots seitlich an das Kupferdepot angesetzt werden. Die Formgebung des zu erzeugenden Lotformteils zur Oberseite wird mittels der zweiten Haltevorrichtung, beispielsweise einer zweiten Keramikplatte, begrenzt. Zusätzlich können Abstandshalter zur genauen Definition der Höhe des zu erzeugenden Lotformteils zwischen den Haltevorrichtungen platziert werden. Durch Aufschmelzen des Lots infiltriert dieses dann das Depot an Kupferpartikeln.

Es kann nicht erfindungsgemäß vorgesehen sein, dass die zweite Phase in Form einer einteiligen Raumstruktur auf einer der beiden Haltevorrichtungen platziert wird. Anschließend wird die zweite Phase in der ersten Phase eingebettet, wobei die erste Phase in Form einer Lotpaste verarbeitet wird. Diese gibt nach, wenn die zweite Phase in diese hineingedrückt wird. Anschließend wird die andere der Haltevorrichtungen auf das herzustellende Lotformteil aufgesetzt. Vorteilhaft kann die einteilige Raumstruktur auch zwischen zwei Schichten der Lotpaste eingebettet werden, um den Füllgrad zu vergrößern. Bei dem Verfahren werden etablierte Techniken des Schablonendrucks angewandt, so dass vorteilhaft ein wirtschaftlicher Herstellungsprozess mit einer hohen Sicherheit durchführbar ist.

Die zweite Phase kann nicht erfindungsgemäß in Form einer einteiligen Raumstruktur verwendet werden und diese Raumstruktur in die geschmolzene erste Phase getaucht wird. Bei diesem Tauchverfahren wird die einteilige Raumstruktur mit dem Lotwerkstoff benetzt, wobei sich sofort eine Diffusionszone in dem noch flüssigen Lotwerkstoff ausbildet. Die so erzeugten, mit Lot benetzten Raumstrukturen können anschließend zu höheren Lotformteilen gestapelt werden.

Weitere Einzelheiten der vorliegenden Offenbarung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1: ein Ausführungsbeispiel des erfindungsgemäßen Lotformteils, bei dem die zweite Phase durch einzelne Lagen gebildet wird, im Schnitt,
- Figur 2: ein Lotformteil, bei dem die zweite Phase durch Partikel gebildet wird, teilweise aufgeschnitten,
- Figur 3 bis 5: ausgewählte Fertigungsschritte eines Ausführungsbeispiels eines Verfahrens (Stapeln von Lagen), teilweise geschnitten,
- Figur 6 und 7: ein anderes Verfahren (Infiltrieren mit Lotmaterial) in ausgewählten Schritten, teilweise geschnitten,
- Figur 8 und 9: ein anderes Verfahren (Tauchen eines Raumgitters) in ausgewählten Schritten, teilweise geschnitten und
- Figur 10 bis 14: ausgewählte Schritte eines anderen Ausführungsbeispiels eines Verfahrens (Lotpastendruck), teilweise geschnitten.

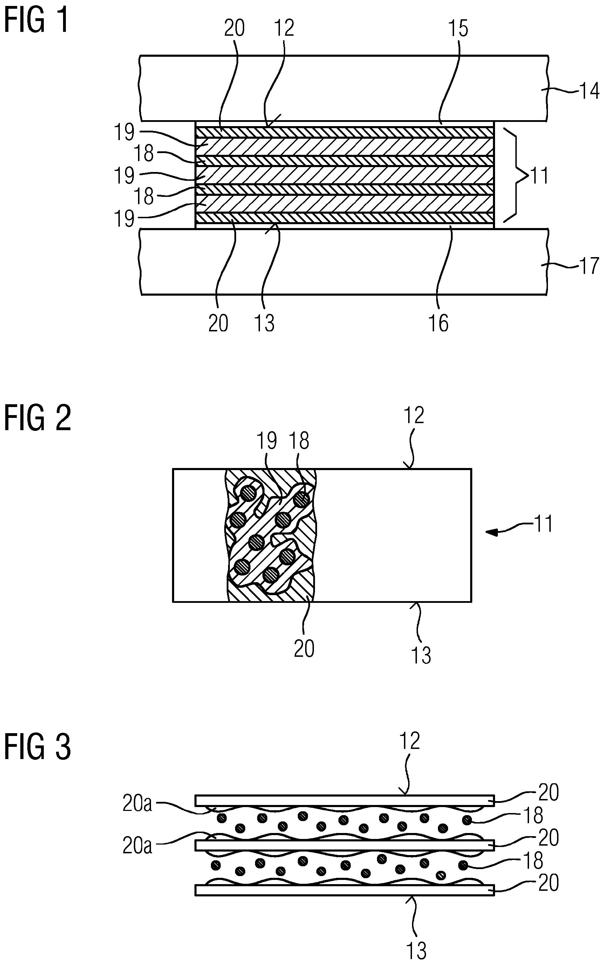

Gemäß Figur 1 ist ein Lotformteil 11 dargestellt. Dieses weist eine erste Fügefläche 12 und eine zweite Fügefläche 13 auf. Über die erste Fügefläche 12 ist das Lotformteil 11 mit einer ersten Metallisierung 15 eines ersten Fügepartners 14 verbunden. Der Fügepartner 14 ist durch ein elektronisches Bauelement ausgeführt. Die zweite Fügefläche 13 ist mit einer zweiten Metallisierung 16 eines zweiten Fügepartners 17 verbunden. Der zweite Fügepartner 17 ist durch einen Schaltungsträger in Form einer Leiterplatte gebildet.

Der Aufbau des Lotformteils 11 ist schematisch dargestellt. In Figur 1 ist ein Zustand dargestellt, bei dem das fertiggestellte Lotformteil 11 zwischen dem ersten Fügepartner 14 und dem zweiten Fügepartner 17 platziert wurde, jedoch noch nicht mit diesen verlötet wurde. Das Lotformteil 11 besteht aus Lagen einer zweiten Phase 18, die aus einem metallischen Werkstoff, erfindungsgemäß Kupfer, gebildet wurden. Zwischen den Lagen dieser zweiten Phase 18 bzw. an diese anschließend befinden sich Diffusionszonen 19, die einen zinnbasierten Lotwerkstoff enthalten, in den Kupfer aus der zweiten Phase 18 eindiffundiert ist. Dies wurde durch eine Wärmebehandlung des Lotformteils erreicht, wobei diese abgebrochen wurde, bevor die Diffusionszonen 19 vollständig ausgebildet wurden, intermetallische Phasen sind teilweise allerdings schon ausgebildet. Außerdem reicht die Diffusionszone 19 noch nicht bis zur ersten Fügefläche 12 und zweiten Fügefläche 13, weswegen diese durch eine erste Phase 20 aus dem zinnhaltigen Lotmaterial gebildet werden.

Nicht dargestellt sind die intermetallischen Verbindungen in den Diffusionszonen (hierzu mehr zu Figur 2). Diese intermetallischen Verbindungen bildet sich bei einem noch folgenden Lötvorgang noch weiter aus, bei dem der erste Fügepartner 14 und der zweite Fügepartner 17 mit dem Lotformteil 11 zu einer Lötverbindung verlötet werden. Dabei diffundiert Material aus der ersten Metallisierung 15 und der zweiten Metallisierung 16 sowie aus der zweiten Phase 18 des Lotformteils in die erste Phase 20 des Lotformteils sowie in die Diffusionszonen 19, wodurch die Konzentration an Kupferatomen in der sich ausbildenden Diffusionszone ausreicht, um intermetallische Verbindungen auszubilden. So entsteht eine Diffusionslötverbindung zwischen dem ersten Fügepartner 14 und dem zweiten Fügepartner 17. Da die Diffusionsvorgänge in dem Lotformteil 11 bereits eingesetzt hatten, ist zum endgültigen Ausbilden der Diffusionslötverbindung weniger Energie erforderlich als bei herkömmlichen Lotformteilen, die zu diesem Zweck verwendet werden.

Bei dem Lotformteil gemäß Figur 2 ist die zweite Phase 18 in Form von Partikeln in der ersten Phase 20 enthalten. Um die zweite Phase 18 herum hat sich bereits eine Diffusionszone 19 (zumindest teilweise) als intermetallische Verbindung ausgebildet. Allerdings gewährleistet ein unter Berücksichtigung der Diffusionswege der zweiten Phase in der ersten Phase (bestimmt durch die Verfahrensparameter der Wärmebehandlung wie Temperatur und Dauer) gewählter Abstand der zweiten Phase 18 von der ersten Fügefläche 12 und der zweiten Fügefläche 13, dass an diesen Fügeflächen die erste Phase 20 des Lotwerkstoffs vorliegt, um einen nachfolgenden Diffusionsvorgang mit nicht dargestellten Fügepartnern sicherzustellen.

Ein Lotformteil gemäß Figur 2 kann beispielsweise mit einem Verfahren der Figuren 3 bis 5 hergestellt werden. In Figur 3 ist dargestellt, dass die erste Phase 20 in Form von Lotfolien abwechselnd mit der ersten Phase 18 in Form von Partikeln geschichtet werden kann. Die erste Phase 18 kann dabei mittels eines dargestellten Binders 20a an die zweite Phase 20 (auf einer Seite oder, wie dargestellt, auf beiden Seiten der Lagen der zweiten Phase) fixiert werden oder einfach nur eingestreut werden (nicht dargestellt). Dabei gewährleistet die jeweils oberste und unterste Lage der ersten Phase 20, dass die zweite Phase 18 von der sich später ausbildenden ersten Fügefläche 12 und zweiten Fügefläche 13 beabstandet sind.

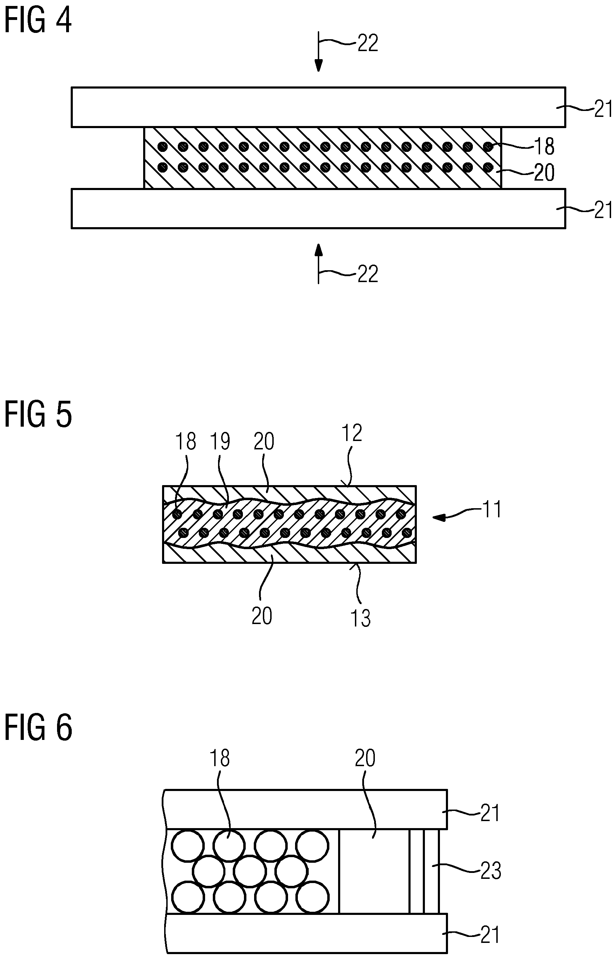

In Figur 4 ist dargestellt, dass der Verbund gemäß Figur 3 zwischen zwei Haltevorrichtungen 21 in Form von Keramikplatten gehalten werden kann. Durch einen Anpressdruck 22 werden die erste Phase 20 und die zweite Phase 18 miteinander verbunden und vorläufig fixiert.

Figur 5 zeigt das Lotformteil 11 nach erfolgter Wärmebehandlung, die erfolgen kann, während das in Entstehung befindliche Lotformteil gemäß Figur 4 in der Haltevorrichtung 21 fixiert ist. Um die erste Phase 18 herum hat sich die Diffusionszone 19 ausgebildet, wobei angrenzend an die erste Fügefläche 12 und die zweite Fügefläche 13 die erste Phase 20 vorhanden ist.

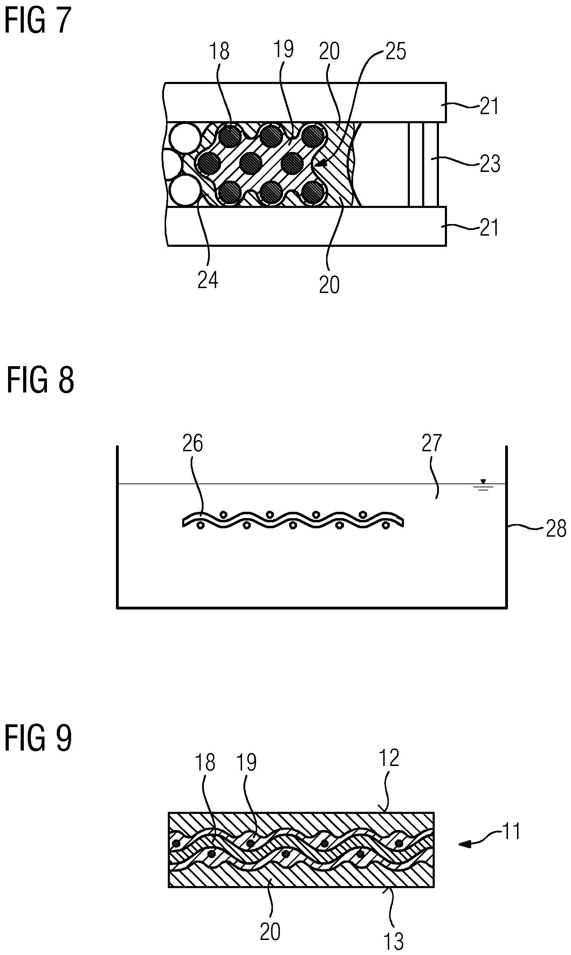

Gemäß Figur 6 und 7 ist ein anderes Verfahren zur Herstellung des Lotformteils dargestellt. In Figur 6 ist zu erkennen, dass die zweite Phase 18 die Form von Kugeln aufweist, die gleichmäßig zwischen den Haltevorrichtungen 21 geschichtet wurden. Die erste Phase 20 des Lotwerkstoffs ist durch ein Formteil ausgebildet, welches ebenfalls zwischen den Haltevorrichtungen 21 gehalten ist und sich am Rande des später auszubildenden Lotformteils befindet. Außerdem ist ein Abstandhalter 23 vorgesehen, der die Höhe des auszubildenden Lotformteils definiert.

In Figur 7 ist dargestellt, dass die Anordnung gemäß Figur 6 so weit erwärmt wird, dass die erste Phase 20 aufschmilzt. Durch die Kapillarkräfte, die durch die Zwischenräume zwischen den Kugeln der ersten Phase 20 erzeugt werden, infiltriert das Lotmaterial nun die erste Phase 18. Zu erkennen in Figur 7 ist eine Front 24 des gerade in die Zwischenräume der zweiten Phase 18 einbringenden Lotwerkstoffs.

Da der Lotwerkstoff flüssig ist, kommt es sofort zu einer Diffusion des Materials der zweiten Phase 18 (z. B. Kupfer) in die erste Phase 20, wodurch eine Diffusionszone 19 aus intermetallischen Verbindungen entsteht. Diese bildet ein die Kugeln der zweiten Phase umgebendes Gerüst 25, welches das fertiggestellte Lotformteil mechanisch stabilisiert, so dass dieses beim späteren Ausbilden einer Lötverbindung stabil bleibt, während der Rest der ersten Phase 20 wieder aufgeschmolzen wird. Der Rest der ersten Phase 20 befindet sich insbesondere an den Grenzflächen zu den Haltevorrichtungen 21, die aus einer Keramik bestehen und daher keine Diffusionsvorgänge in der ersten Phase 20 auslösen oder sich von der flüssigen ersten Phase 20 benetzen lassen.

Gemäß den Figuren 8 und 9 ist ein anderes Verfahren zum Herstellen des Lotformteils dargestellt. Bei diesem Verfahren soll die zweite Phase aus einer dreidimensionalen Raumstruktur 26, hier ein Drahtgitter, gebildet werden. Um aus dieser Raumstruktur 26 ein Lotformteil herzustellen, wird diese in flüssiges Lot 27 getaucht, welches in einem Behälter 28 zur Verfügung gestellt wird.

In Figur 9 ist zu erkennen, dass das Raumgitter 26 aus Figur 8 bei dem fertiggestellten Lotformteil 11 die zweite Phase 18 bildet. Diese ist von der Diffusionszone 19 umgeben, wobei mit zunehmendem Abstand zur zweiten Phase 18 die erste Phase 20 die Diffusionszone 19 ablöst, so dass die erste Fügefläche 12 und die zweite Fügefläche 13 von der ersten Phase 20 gebildet werden.

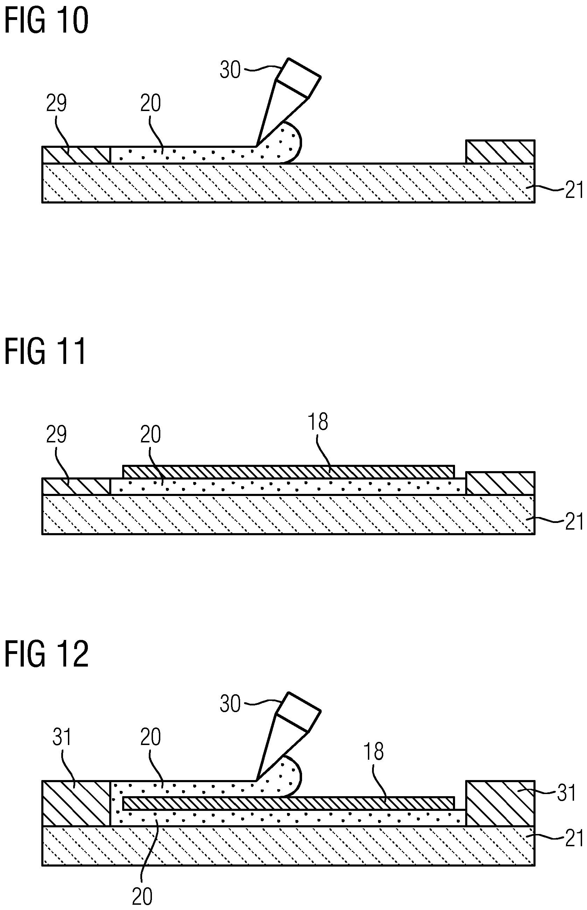

In den Figuren 10 bis 14 ist ein Verfahren zur Herstellung des Lötformteils 11 durch Lotpastendruck dargestellt. In Figur 10 ist zu erkennen, dass auf die Haltevorrichtung 21 in Form einer Keramikplatte eine erste Schablone 29 aufgelegt wird und mittels einer Rakel 30 die zweite Phase 20 in Form einer Lotpaste in einer bestimmten Dicke aufgetragen wird. Wie Figur 11 zu entnehmen ist, kann auf die so applizierte erste Phase 20 die zweite Phase 18 in Form einer Kupferfolie aufgelegt werden. Anschließend wird, wie in Figur 12 dargestellt, die erste Schablone 29 durch eine zweite Schablone 31 ersetzt, die eine größere Höhe aufweist. Alternativ (nicht dargestellt) kann die erste Schablone 29 auch auf der Haltevorrichtung 21 verbleiben und auf die erste Schablone 29 eine weitere Schablone aufgelegt werden. In jedem Fall vertieft sich damit auch die durch die zweite Schablone 31 entstehende Kavität, so dass mittels der Rakel 30 zur Erzeugung der ersten Phase 20 weitere Lotpaste dosiert werden kann. Auf diese Weise wird die erste Phase 18 in der zweiten Phase 20 eingeschlossen. Dieser Vorgang kann mehrfach wiederholt werden, bis die gewünschte Dicke für das Lotformteil erreicht ist.

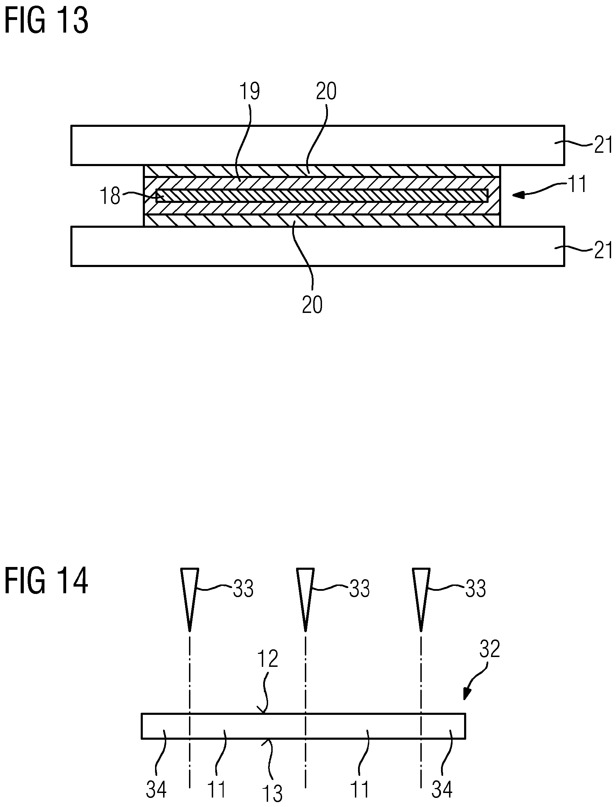

In Figur 13 ist dargestellt, wie in einem nachfolgenden Schritt ein gemäß Figur 10 bis 12 hergestelltes Lotformteil 11 mit einer zweiten Haltevorrichtung 21 versehen werden und einer Wärmebehandlung unterworfen werden kann. Hierbei entsteht um die zweite Phase 18 herum die Diffusionszone 19 mit einer Intermetallischen Verbindung, wobei jenseits der Diffusionszone 19 die erste Phase 20 vorliegt.

Als Bauteil gemäß den Figuren 10 bis 13 kann statt einem einzelnen Lotformteil 11 gemäß Figur 14 auch eine Platte 32 erzeugt werden, die eine wesentlich größere Fläche als die zu erzeugenden Lotformteile 11 aufweist. Diese Platte 32 kann dann mittels einer Trennvorrichtung 33 z. B. durch Stanzen vereinzelt werden, d. h., dass die Lotformteile 11 voneinander getrennt werden (Trennung entlang der Strichpunktlinien). Randbereiche 34, in denen die geforderte Struktur für das Lotformteil nicht vorliegt oder sich horizontale Toleranzen auswirken, können abgetrennt und verworfen werden.

## Patentansprüche

1. Lotformteil aus einem Gefüge zum Erzeugen einer Diffusionslötverbindung,
• aufweisend eine erste Fügefläche (12) für einen ersten Fügepartner (14) und eine zweite Fügefläche (13) für einen zweiten Fügepartner (17),
• wobei das Gefüge eine erste Phase (20) aus einem zinnbasierten Lotwerkstoff und eine zweite Phase (18) aus Kupfer aufweist, wobei
in dem Lotformteil eine aus dem Material der ersten Phase (20) und dem Material der zweiten Phase (18) bestehende Diffusionszone (19) ausgebildet ist, wobei
• die erste Fügefläche (12) und die zweite Fügefläche (13) ganz oder teilweise durch die erste Phase (20) ausgebildet sind,
• die Diffusionszone (19) eine intermetallische Verbindung aufweist,
wobei zwischen der Diffusionszone (19) und der ersten Fügefläche (12) sowie zwischen der Diffusionszone (19) und der zweiten Fügefläche (13) ein Mindestabstand besteht, der im Bereich von mindestens 1 µm und höchstens 30 µm liegt,
wobei die erste Phase (20) und die zweite Phase (18) als Lagen in dem Lotformteil ausgebildet sind, wobei jeweils zwischen diesen Lagen die Diffusionszonen (19) als Zwischenlagen ausgebildet sind,
**dadurch gekennzeichnet, dass** der Mindestabstand zwischen der Diffusionszone (19) und der ersten Fügefläche (12) sowie zwischen der Diffusionszone (19) und der zweiten Fügefläche (13) in einem Bereich unterhalb der Fügefläche (12) von mindestens 70 % vorliegt.

2. Lotformteil nach Anspruch 1,
**dadurch gekennzeichnet, dass** der besagte Mindestabstand zwischen der Diffusionszone (19) und der ersten Fügefläche (12) sowie zwischen der Diffusionszone (19) und der zweiten Fügefläche (13) in einem Bereich unterhalb der Fügefläche (12) von mindestens 90 % vorliegt.

3. Lotformteil nach Anspruch 1 oder 2, wobei der Mindestabstand zwischen der Diffusionszone (19) und der ersten Fügefläche (12) sowie zwischen der Diffusionszone (19) und der zweiten Fügefläche (13) im Bereich von mindestens 5 µm und höchstens 10 um liegt.

## Claims

1. Solder preform made of a microstructure for establishing a diffusion solder connection,
• comprising a first joining surface (12) for a first joining partner (14) and a second joining surface (13) for a second joining partner (17),
• wherein the microstructure comprises a first phase (20) made of a solder material and a second phase (18) made of copper, wherein
a diffusion zone (19) consisting of the material of the first phase (20) and the material of the second phase (18) is formed in the solder preform, wherein
• the first joining surface (12) and the second joining surface (13) are entirely or partially formed by the first phase (20),
• the diffusion zone (19) comprises an intermetallic compound,
wherein a minimum distance, which is in the range of at least 1 µm and at most 30 µm, exists between the diffusion zone (19) and the first joining surface (12) and also between the diffusion zone (19) and the second joining surface (13), wherein the first phase (20) and the second phase (18) are formed as layers in the solder preform, wherein the diffusion zones (19) are respectively formed as intermediate layers between these layers,
**characterized in that** the minimum distance between the diffusion zone (19) and the first joining surface (12) and also between the diffusion zone (19) and the second joining surface (13) is present in a region below the joining surface (12) of at least 70%.

2. Solder preform according to Claim 1,
**characterized in that** said minimum distance between the diffusion zone (19) and the first joining surface (12) and also between the diffusion zone (19) and the second joining surface (13) is present in a region below the joining surface (12) of at least 90%.

3. Solder preform according to Claim 1 or 2, wherein the minimum distance between the diffusion zone (19) and the first joining surface (12) and also between the diffusion zone (19) and the second joining surface (13) is in the range of at least 5 µm and at most 10 µm.

## Revendications

1. Préforme de brasage en une texture de production d'un composé de brasage par diffusion,
• comportant une première surface (12) de jonction pour un premier partenaire (14) de jonction et une deuxième surface (13) de jonction pour un deuxième partenaire (17) de jonction,
• dans laquelle la texture a une première phase (20) en un matériau de brasage à base d'étain et une deuxième phase (18) en cuivre, dans laquelle
dans la préforme de brasage est constituée une zone (19) de diffusion consistant en le matériau de la première phase (20) et le matériau de la deuxième phase (18), dans laquelle
• la première surface (12) de jonction et la deuxième surface (13) de jonction sont constituées en tout ou partie par la première phase (20),
• la zone (19) de diffusion comporte un composé intermétallique,
dans laquelle entre la zone (19) de diffusion et la première surface (12) de jonction, ainsi qu'entre la zone (19) de diffusion et la deuxième surface (13) de jonction, il y a une distance minimum, qui est de l'ordre d'au moins 1 µm et d'au plus 30 µm, dans laquelle la première phase (20) et la deuxième phase (18) sont constituées sous la forme de couches dans la préforme de brasage, dans lequel, entre ces couches, les zones (19) de diffusion sont constituées sous la forme de couches intermédiaires,
**caractérisée en ce que** la distance minimum entre la zone (19) de diffusion et la première surface (12) de jonction, ainsi qu'entre la zone (19) de diffusion et la deuxième surface (13) de jonction, est dans une plage en-dessous de la surface (12) de jonction d'au moins 70 %.

2. Préforme de brasage suivant la revendication 1,
**caractérisée en ce que** ladite distance minimum entre la zone (19) de diffusion et la première surface (12) de jonction, ainsi qu'entre la zone (19) de diffusion et la deuxième surface (13) de jonction, est dans une plage en-dessous de la surface (12) de jonction d'au moins 90 %.

3. Préforme de brasage suivant la revendication 1 ou 2, dans laquelle la distance minimum entre la zone (19) de diffusion et la première surface (12) de jonction, ainsi qu'entre la zone (19) de diffusion et la deuxième surface (13) de jonction, est dans une plage d'au moins 5 µm et d'au plus 10 µm.
